# EUROPÄISCHE PATENTSCHRIFT

(11) **EP 2 661 778 B1**
(45) Veröffentlichungstag und Bekanntmachung des Hinweises auf die Patenterteilung: **28.01.2015**
(21) Anmeldenummer: 11807664.5
(22) Anmeldetag: 16.12.2011
(51) Int. Cl.: H01L 51/52, F21Y 105/00

(54) **LEUCHTE MIT FLEXIBLER OLED UND RAHMEN**
LUMINAIRE WITH FLEXIBLE OLED AND FRAME
DISPOSITIF D'ÉCLAIRAGE A OLED SOUPLE ET CADRE

(30) Priorität: 05.01.2011 DE 102011002480
(43) Veröffentlichungstag der Anmeldung: 13.11.2013
(73) Patentinhaber: Trilux GmbH & Co. KG, 59759 Arnsberg (DE)
(72) Erfinder: RUDOLPH, Horst, 59067 Hamm (DE); LUDWIG, Sebastian, 50735 Köln (DE)
(74) Vertreter: Lippert, Stachow & Partner
(86) Internationale Anmeldenummer: PCT/EP2011/073057
(87) Internationale Veröffentlichungsnummer: WO 2012/093025

(56) Entgegenhaltungen:
- EP-A2- 1 367 677
- WO-A1-2009/136305
- WO-A1-2010/066245

## Beschreibung

Die Erfindung betrifft eine Leuchte mit einer flexiblen organischen Leuchtdiode (OLED), die mit einem Rahmen versehen ist.

OLED können mit relativ hohem Wirkungsgrad elektrische Energie in Licht umwandeln. Sie sind meist aus mehreren organischen Schichten aufgebaut, darunter eine Elektronen leitende Emitterschicht und eine Löcher (Defektelektronen) leitende Schicht. Außerdem sind Elektrodenschichten zur Injektion der Elektronen und Löcher in die organischen Schichten vorhanden. Durch Rekombination von Elektronen und Löchern werden in den organischen Schichten über Zwischenstufen Photonen erzeugt. Infolge der stürmischen Entwicklung auf dem Gebiet der OLED könnten diese schon bald wirtschaftlich für allgemeine Beleuchtung eingesetzt werden. Sie lassen sich großflächig herstellen und geben dann ein diffuses, angenehmes Licht mit geringer Schattenbildüng und Blendung ab. Da die Licht emittierenden Schichten und die Elektrodenschichten aus wirtschaftlichen und technischen Gründen relativ dünn gehalten werden, versieht man die OLED-Anordnung meist noch mit flexiblen Schutzschichten oder auch starren Trägern.

Bei den heute verwendeten OLED sind die Schichten häufig zwischen Glasplatten eingeschlossen und an den Rändern versiegelt, um eine rasche Alterung durch Zutritt von Feuchtigkeit und Sauerstoff zu verhindern. Neuerdings gelingt es jedoch, die Empfindlichkeit der Schichten gegen solche atmosphärischen Einflüsse durch geeignete Stoffauswahl zu vermindern, so dass auch beispielsweise Kunststofffolien trotz ihrer geringeren Sperrwirkung für Feuchtigkeit und Sauerstoff als Träger beziehungsweise Deckschicht infrage kommen. Damit ist eine Reihe von Vorteilen verbunden, wie leichtere Herstellung in großem Maßstab mittels bekannter Druck- bzw. Beschichtungstechnik, leichtere Anpassung an vorgegebene Abmessungen und Formen, geringeres Gewicht und niedrigerer Preis. Es fehlt jedoch noch an Leuchtenvorrichtungen, die geeignet sind, eine solche flexible OLED in einer gewünschten Form und beliebiger Größe zu verwenden, wobei die genannten Vorteile erhalten bleiben sollen.

In der WO 2010/066245 A1 werden Beleuchtungsmittel mit transparenter, beidseitig emittierender OLED angegeben, die eine Weckfunktion haben und in unterschiedlichen Formen, beispielsweise als Decken- oder Wandleuchte, als Wand für Umkleide- oder Duschkabinen oder als leuchtender Vorhang, gestaltet sind. Es wird jedoch nicht offenbart, wie die unterschiedlichen Gestaltungen erreicht werden.

Es ist daher die Aufgabe der vorliegenden Erfindung, eine Leuchte mit einer flexiblen OLED bereitzustellen, deren Größe und Form in weiten Grenzen variiert werden können und die sich darüber hinaus durch geringes Gewicht auszeichnet.

Diese Aufgabe wird durch eine OLED-Leuchte nach dem Hauptanspruch gelöst.

Weil der Rahmen der Leuchte aus mehreren, mindestens jedoch zwei Teilen besteht, kann durch unterschiedliche Kombination dieser Teile nach Art eines Baukastensystems mit einer OLED eine Vielzahl unterschiedlicher Formen realisiert werden.

Die flexible OLED wird in dem erfindungsgemäß bereitgestellten Rahmen aufgespannt. Dann sind keine stützenden und schweren großflächigen Platten notwendig. Dadurch wird ein sehr geringes Gewicht der Leuchte erreicht. Dementsprechend können Einrichtungen zur Befestigung der Leuchte an Decken, Wänden usw. klein dimensioniert werden, was neben Material- und Kosteneinsparung auch ästhetische Vorteile bietet.

Die Teile des Rahmens sind lösbar miteinander verbunden. Dies kann beispielsweise durch Ineinanderstecken, ggf. mit zusätzlicher Sicherung durch Splinte oder Madenschrauben, geschehen. Es ist auch möglich, die Teile mit Gewindestiften bzw. -hülsen auszubilden, die sich miteinander verschrauben lassen.

Der Rahmen der erfindungsgemäßen Leuchte ist vorteilhaft rechteckig ausgebildet. Dann können die in den Rahmen einzubauenden OLED leicht und ohne Verschnittverluste aus Rollenware angefertigt werden. Auch wird der ästhetische Eindruck solcher Leuchten oft als angemessen empfunden.

Eine Möglichkeit zur Veränderung der Größe der Leuchte ergibt sich bei solchen rechteckigen Rahmen, wenn mindestens zwei gegenüberliegende Seiten des Rechtecks teleskopartig verkürzbar sind. Dies kann beispielsweise realisiert werden, wenn Abschnitte eines Rahmenteils aus ähnlichen Profilen abgestufter Durchmesser hergestellt werden, die ineinander geschoben werden können.

Um die Veränderung der Größe der Leuchte zu erleichtern, kann es vorteilhaft sein, in mindestens einem Teil des Rahmens eine Aufrollvorrichtung vorzusehen. Mit dieser Vorrichtung kann beispielsweise ein Teil der OLED aufgerollt werden, wenn ggf. vorübergehend eine kleinere Leuchte gewünscht wird, und entsprechend der aufgerollte Teil der OLED wieder abgerollt werden, wenn die Leuchte vergrößert wird. Die Größenänderung kann beispielsweise durch Einschieben und Auseinanderziehen der teleskopartigen Teilen erfolgen, aber ebenso gut auch durch Ersetzen von Teile durch andere Teile oder Ausbau bzw. Einbau weiterer Teile. Die Aufrollvorrichtung kann mit Mitteln zum Spannen der OLED versehen sein.

Weitere Gestaltungsfreiheit für die erfindungsgemäße Leuchte ergibt sich, wenn bestimmte Seiten des Rahmens eine.Biegung aufweisen. Zweckmäßig, aber nicht notwendig ist eine solche Biegung an sich gegenüberliegenden Seiten des Rahmens vorgesehen.

Solche Biegungen lassen sich beispielsweise realisieren, wenn für den Ausbau des Rahmens neben geraden Teilen auch Bogenstücke, beispielsweise Achtel-, Viertel- oder Halbkreisbogenstücke eingebaut werden. Es ist aber auch möglich, die Biegung mittels biegsamer Stäbe oder Drähte zu realisieren. Dabei sind diese nach Material und Abmessung so auszuwählen, dass sie sich mit größerem Kraftaufwand plastisch verformen lassen, unter dem Einfluss der beim Gebrauch der Leuchte einwirkenden Kräfte aber ihre Form behalten. Biegsame Stäbe können beispielsweise nach dem Prinzip eines biegsamen Kurvenlineals aufgebaut sein, bei dem sich ein Bleistab mit Rechteckprofil von Stahlfedern umgeben in einer Hülle aus elastischem Material befindet. In analoger Weise lassen sich auch Gliederstäbe verwenden, deren Glieder durch Reibungskraft in ihrer gegenseitigen Orientierung fixiert sind, durch Überwinden der Reibung aber gegeneinander geschwenkt werden können. Selbstverständlich können auch solche Teile mit den oben erwähnten Mitteln zur lösbaren Verbindung untereinander versehen sein.

Eine weitere Ausführungsform der erfindungsgemäßen Leuchte ergibt sich, wenn der Rahmen zwei voneinander getrennte Teile umfasst, welche die Gestalt geschlossener Kurven haben. Diese Teile können ihrerseits aus den vorstehend erwähnten Teilen zur Realisierung von Biegungen, beispielsweise Bogenstücken, zusammengesetzt oder auch im Ganzen, etwa in Form von Kreisen, Ellipsen, Polygonen, hergestellt und verwendet werden. Mit solchen Teilen lassen sich beispielsweise Leuchten in angenäherter Form von Zylindern, Kegeln und Kegelstümpfen, Prismen, Pyramiden und Pyramidenstümpfen realisieren.

Die flexiblen OLED können sowohl als transparente als auch als intransparente OLED ausgebildet sein. Transparente Systeme sind beispielsweise mit klaren Träger- und Deckfolien versehen und strahlen das Licht nach beiden Seiten annähernd gleichmäßig und lambertsch ab. Intransparente Folien weisen auf einer Seite eine Licht reflektierende oder undurchlässige Folie und/oder auf der anderen Seite eine für die bevorzugte Auskopplung besonders strukturierte Folie auf, Während letztere sich bevorzugt für Wand- und Deckenleuchten eignen, können transparente OLED für Standleuchten zur allgemeinen Raumbeleuchtung vorteilhaft sein. Dabei ist günstig, dass die erfindungsgemäße Leuchte auf der Fläche der OLED keine Stütz- oder Trageeinrichtungen wie Platten aufweist, welche Licht absorbieren könnten.

Die Befestigung der flexiblen OLED im Rahmen geschieht bevorzugt mittels Klemmen oder Magneten. Hierzu können Magnete an der OLED befestigt, z. B. angeklebt sein. Alternativ können eine oder mehrere Seiten der flexiblen OLED mittels an den Innenseiten der Rahmenteile angebrachten Leisten, Schienen oder Nuten geführt bzw. gehalten werden.

Die Versorgung der OLED mit elektrischer Energie kann beispielsweise über ein Vorschaltgerät erfolgen, das in eines der Rahmenteile integriert ist. Die Stromzufuhr kann dabei beispielsweise über die ggf. vorhandenen Befestigungsklemmen erfolgen.

Die große Variabilität der erfindungsgemäßen Leuchte kann man sich bei der rationellen Herstellung von Leuchten unterschiedlicher Gestaltung aus einer begrenzten Anzahl von Teilen zunutze machen. Es ist aber auch möglich, dem Endverbraucher einen entsprechenden Bausatz anzubieten und die persönliche Gestaltung seiner Leuchte zu überlassen. In einem solchen Bausatz wird vorteilhaft mindestens ein Teil mit integrierten Betriebsgeräten, wie beispielsweise Anschlusselemente, Schalter, Transformatoren, Vorwiderstände, Gleichrichter, vorgesehen.

Neben einem geringen Gewicht zeichnet sich die erfindungsgemäße Leuchte durch geringe Bautiefe, hohe Transparenz, d. h. geringe Lichtverluste, und Flexibilität der Gestaltungsmöglichkeiten aus.

Die Erfindung wird nachstehend anhand konkreter bevorzugter Ausführungsbeispiele unter Bezugnahme auf die beigefügten Zeichnungen näher erläutert. Es zeigen
- Figur 1: einen zweiteiligen rechteckigen Rahmen mit veränderbarer Länge in perspektivischer Ansicht,
- Figur 2: eine Aufrollvorrichtung in einem Rahmenteil in perspektivischem Schnitt,
- Figur 3: eine erfindungsgemäße Leuchte als Standleuchte,
- Figur 4: eine Leuchte mit einem Rahmen mit zwei geraden und zwei gebogenen Seiten in perspektivischer Ansicht,
- Figur 5: ein Stecksystem mit Bogenstücken in Seitenansicht,
- Figur 6: eine zylindrische Leuchte in perspektivischer Ansicht,
- Figur 7: eine Leuchte entsprechend Figur 1 als Deckenleuchte mit zusätzlichen Leuchtdioden auf dem Rahmen von unten gesehen.

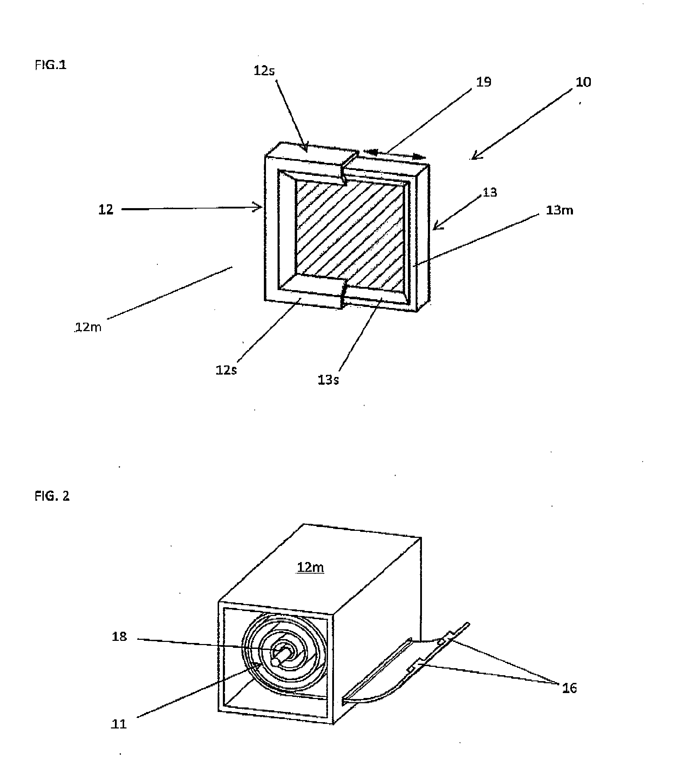

Die in Figur 1 dargestellte Leuchte 10 umfasst ein äußeres Rahmenteil 12 und ein inneres Rahmenteil 13. Beide Rahmenteile sind U-förmig und umfassen jeweils ein Mittelteil 12m bzw. 13m sowie an deren Enden rechtwinklig angesetzt jeweils zwei Seitenteile 12s bzw. 13s. Die Seitenteile 12s des äußeren Rahmenteils sind hohl und nehmen in ihrem inneren Hohlraum die Seitenteile 13s des inneren Rahmenteils auf. In dem so gebildeten Rahmen ist die flexible OLED 11 aufgespannt, indem sie an mindestens zwei sich gegenüberliegenden Seiten des Rahmens mit ihren entsprechenden Seitenkanten befestigt ist. Diese Befestigung kann durch Magnete in der Nähe der Seitenkanten der OLED erfolgen, die mit ferromagnetischem Material auf den Rahmenseiten zusammenwirken. Die anderen beiden Seiten werden in Schienen an den Innenseiten der Rahmenseitenteile 12s bzw. 13s gehalten und geführt. Durch Verschiebung des inneren Rahmenteils in Richtung des Pfeils 19 kann die Größe des Rahmens verändert werden. Der Rahmen weist außerdem elektrische Anschüsse auf, die mit entsprechenden Anschlüssen auf der OLED verbunden werden können, um diese zum Leuchten anzuregen. Da die elektrisch leitenden Schichten der OLED einen gewissen Widerstand aufweisen, so dass zwischen Anschlusspunkten und entfernteren Bereichen ein Spannungsabfall mit entsprechender Verminderung der Lichtemission stattfindet, kann es zweckmäßig sein, Leiterbahnen zum gleichmäßigen Verteilen der angelegten Spannung vorzusehen. Diese können beispielsweise auf Kantenbereichen der OLED, die vom Rahmen verdeckt sind, oder auch auf dem Rahmen vorgesehen sein.

Ein Detail einer speziellen Ausführungsform der erfindungsgemäßen Leuchte nach Figur 1 zeigt Figur 2. Hierbei ist der Mittelteil des äußeren Rahmenteils 12m hohl und beherbergt eine Vorrichtung zum Aufwickeln der flexiblen OLED 11 mit einem Wickeldorn 18. Das freie Ende der OLED 11 ist mit Magneten 16 versehen, die auf dem Mittelteil 13m des inneren Rahmenteils festgelegt werden. Der Wickeldorn 18 ist mit einer (hier nicht gezeigten) Spannvorrichtung in Form einer Spiralfeder versehen. Zusätzlich kann eine Arretierung nach dem Prinzip des Schnapprollos vorgesehen sein. Diese Ausführungsform erlaubt in besonders einfacher Weise, durch Hineinschieben bzw. Herausziehen des inneren Rahmenteils 13 die Licht nach außen abstrahlende Fläche der Leuchte zu verändern.

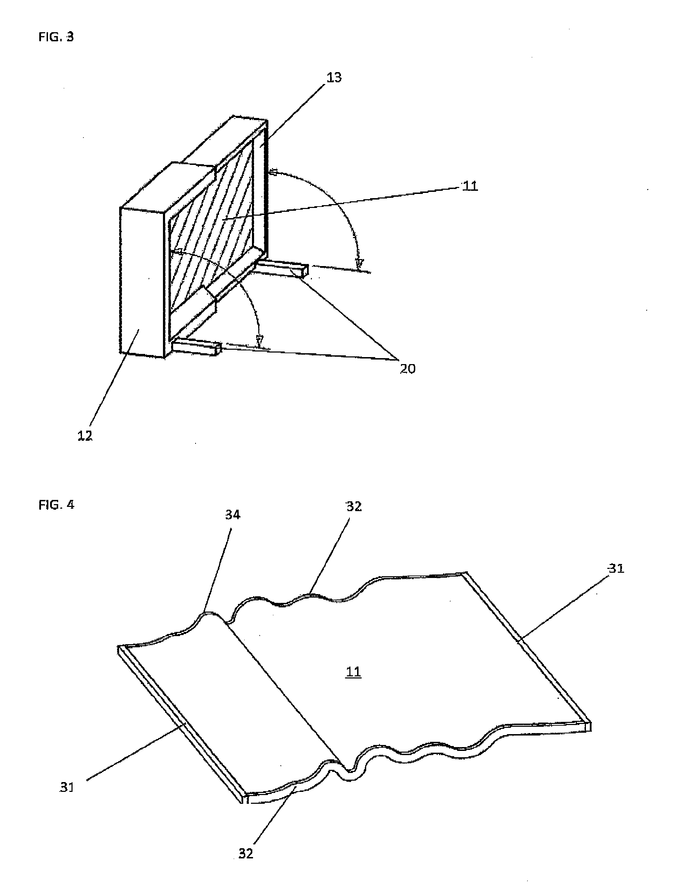

Eine solche Leuchte kann mit geeigneten Befestigungsmitteln, beispielsweise Schrauben, Ösen, Aufhängeseilen, an Wänden oder Decken aufliegend oder hängend befestigt werden. Sie kann aber auch, vorzugsweise am äußeren Rahmenteil 12, mit Querstreben 20 versehen sein, die einen sicheren Stand auf dem Fußboden ermöglichen, wie in Figur 3 gezeigt. Die Querstreben 20 können für die Wand- oder Deckenmontage einklappbar sein. Die Standleuchte lässt sich so groß herstellen, dass sie neben der Beleuchtungsfunktion auch als Raumteiler oder spanische Wand verwendet werden kann. Dazu lassen sich auch mehrere Leuchten leporelloartig verbinden.

In einer anderen Ausführungsform (Figur 4) ist die flexible OLED 11 zwischen zwei sich gegenüberliegenden geraden starren Rahmenteilen 31 und zwei gebogenen Rahmenteilen 32 aufgespannt. Die gebogenen Teile 32 sind flexibel, sodass die Leuchte auch im Betrieb in einer Vielfalt von Formen gestaltet werden kann. Dabei brauchen die geraden Rahmenteile 31 nicht parallel in derselben Ebene geführt zu werden. Zur Befestigung der OLED 11 an den biegsamen Rahmenteilen 32 sind Führungsnuten 34 vorgesehen.

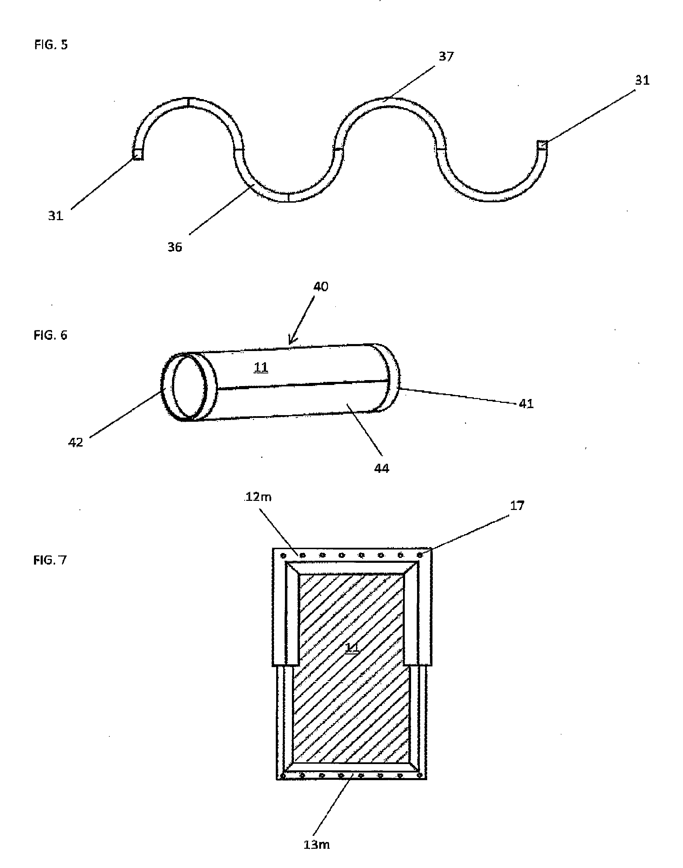

Figur 5 zeigt eine spezielle Ausführungsform der Leuchte nach Figur 4 mit gebogenen, aber starren Rahmenteilen in der Seitenansicht. Dabei sind die gebogenen Teile aus Viertelkreisbögen 36 und Halbkreisbögen 37 zusammengesteckt und mit den geraden Rahmenteilen 31 durch eine Steckverbindung verbunden. Dieser Aufbau ist nur beispielhaft und lässt erkennen, dass mit weiteren gleichartigen Bauteilen eine große Vielfalt von Gestaltungen möglich ist.

Noch eine andere Ausführungsform der erfindungsgemäßen Leuchte 40 (Figur 6) weist eine zu einem Zylinder gebogene flexible OLED 11 auf, deren Rahmen aus zwei kreisförmigen Elementen 41, 42 gebildet ist. Diese Leuchte kann mit dem Rahmenteil 42 senkrecht auf einen Fuß gestellt werden, der auch die Stromversorgung umfasst, wobei über die längs der Seitenlinie des Zylinders verlaufende Leiterbahn 44 das Rahmenteil 41 mit. Spannung versorgt wird.

Schließlich zeigt Figur 7 eine erfindungsgemäße Leuchte 10 entsprechend Figur 1, die als Deckenleuchte vorgesehen ist. Hierbei sind auf den mittleren Rahmenteilen 12m bzw. 13m noch weitere konventionelle Leuchtdioden 17 angebracht, um bestimmte Bereiche stärker ausleuchten zu können. Diese LED können eine gemeinsame Stromversorgung mit der OLED haben.

### Bezugszeichenliste

- 10: Leuchte
- 11: flexible OLED
- 12: äußeres Rahmenteil
- 13: inneres Rahmenteil
- 12m, 13m: Mittelteile
- 12s, 13s: Seitenteile
- 16: Magnete
- 17: Leuchtdiode
- 18: Wickeldorn
- 19: Richtung der Verschiebbarkeit
- 20: Querstrebe
- 31: starres Rahmenteil
- 32: gebogenes Rahmenteil
- 36: Viertelkreisbogen
- 37: Halbkreisbogen
- 40: Zylinderleuchte
- 41, 42: kreisförmige Rahmenelemente
- 44: Leiterbahn

## Patentansprüche

1. Leuchte (10) mit einer flexiblen organischen Leuchtdiode (OLED) (11), die an mindestens einer Seite eines die OLED (11) seitlich umgebenden Rahmens befestigt ist, **dadurch gekennzeichnet, dass** der Rahmen aus mindestens zwei Teilen (12, 13) besteht, die lösbar miteinander verbunden sind, wobei die Teile ineinander gesteckt und/oder miteinander verschraubt sind oder dass der Rahmen zwei voneinander getrennte Teile (41, 42) umfasst, welche die Gestalt geschlossener Kurven haben, und wobei ferner in beiden Fällen die OLED (11) an zwei mindestens sich gegenüberliegenden Seiten des Rahmens mit ihren entsprechenden Seitenkanten aufgespannt ist.

2. Leuchte nach Anspruch 1, **dadurch gekennzeichnet, dass** der Rahmen rechteckig ist.

3. Leuchte nach Anspruch 2, **dadurch gekennzeichnet, dass** mindestens zwei gegenüberliegende Seiten teleskopartig verkürzbar sind.

4. Leuchte nach einem der Ansprüche 1 bis 3, **dadurch gekennzeichnet, dass** mindestens eine Seite des Rahmens mit einer Aufrollvorrichtung (18) für die flexible OLED (11) versehen ist.

5. Leuchte nach Anspruch 1, **dadurch gekennzeichnet, dass** der Rahmen vierseitig ist und zwei sich gegenüberliegende Seiten (32) jeweils mindestens eine Biegung aufweisen.

6. Leuchte nach Anspruch 5, **dadurch gekennzeichnet, dass** die mindestens eine Biegung aufweisenden Seiten Bogenstücke, biegsame Stäbe oder Gliederstäbe umfassen.

7. Leuchte nach einem der vorangehenden Ansprüche, **dadurch gekennzeichnet, dass** die OLED am Rahmen mittels Klemmen oder Magneten (16) befestigt sind.

8. Bausatz zur Herstellung einer Leuchte nach einem der vorangehenden Ansprüche, umfassend mehrere Teile zur Bildung eines Rahmens.

9. Bausatz nach Anspruch 8, **dadurch gekennzeichnet, dass** in mindestens eines der Teile Betriebsgeräte für die Leuchte integriert sind.

## Claims

1. Luminaire (10) with a flexible organic light emitting diode (OLED) (11), which is fixed to at least one side of a frame laterally surrounding said OLED (11), **characterized in that** said frame consists of at least two parts (12, 13) connected to each other in a detachable manner, said parts being plug-fitted one into the other and/or screwed together, or that said frame comprises two parts (41, 42) separate from each other and having the form of closed curves, and wherein further in both cases said OLED (11) is clamped with its corresponding lateral edges to at least two opposing sides of the frame.

2. Luminaire according to claim 1, **characterized in that** said frame is rectangular.

3. Luminaire according to claim 2, **characterized in that** at least two opposing sides can be shortened in a telescoping manner.

4. Luminaire according to one of the claims 1 to 3, **characterized in that** at least one side of the frame is provided with a reeling device (18) for the said flexible OLED (11).

5. Luminaire according to claim 1, **characterized in that** the frame is foursided and that two mutually opposite sides (32) each include at least one bend.

6. Luminaire according to claim 5, **characterized in that** said sides including said at least one bend comprise bow-pieces, flexible rods or link rods.

7. Luminaire according to any one of the preceding claims, **characterized in that** the OLEDs are fixed to the frame by clamps or magnets (16).

8. Assembly kit for assembling a luminaire according to one of the preceding claims, comprising several parts for building a frame.

9. Assembly kit according to claim 8, **characterized in that** operation devices for said luminaire are integrated in at least one of said parts.

## Revendications

1. Dispositif d'éclairage (10) à diode électroluminescente organique souple (OLED) (11) fixée à un côté au moins d'un cadre entourant latéralement ladite OLED (11), **caractérisé en ce que** le cadre consiste en au moins deux parties (12, 13) reliées l'une à l'autre de manière détachable, les parties étant enfichées l'une dans l'autre et/ou vissées l'une avec l'autre, ou que le cadre comporte deux parties (41, 42) séparées l'une de l'autre et présentant une forme de courbes fermées, et ladite OLED (11), dans les deux cas, en outre étant serrée aux au moins deux côtés opposés du cadre par ses bords latéraux correspondants.

2. Dispositif d'éclairage la revendication 1, **caractérisé en ce que** le cadre est rectangulaire.

3. Dispositif d'éclairage selon la revendication 2, **caractérisé en ce qu'**au moins deux côtés opposés peuvent être accourcis de manière télescopique.

4. Dispositif d'éclairage selon l'une des revendications 1 à 3, **caractérisé en ce qu'**au moins un côté du cadre est muni d'un enrouleur (18) pour ladite OLED (11) flexible.

5. Dispositif d'éclairage selon la revendication 1, **caractérisé en ce que** le cadre est quadrilatéral et que deux côtes opposés (32) chacun présentent au moins une courbure.

6. Dispositif d'éclairage selon la revendication 5, **caractérisé en ce que** les côtés présentant ladite au moins une courbure comprend des pièces archées, des baguettes flexibles ou des baguettes à maillon.

7. Dispositif d'éclairage selon l'une des revendications précédentes, **caractérisé en ce que** ladite OLED est fixée audit cadre moyennant des pinces ou des aimants (16).

8. Kit pour composer un dispositif d'éclairage selon l'une des revendications précédentes, comprenant plusieurs parties pour former un cadre.

9. Kit selon la revendication 8, **caractérisé en ce que** dans l'une au moins desdites parties sont intégrés des dispositifs d'opération pour le dispositif d'éclairage.
